# EUROPÄISCHE PATENTANMELDUNG

(11) **EP 3 621 423 A1**
(43) Veröffentlichungstag der Anmeldung: **11.03.2020**
(21) Anmeldenummer: 19193521.2
(22) Anmeldetag: 26.08.2019
(51) Int. Cl.: H05K 9/00

(54) **VORRICHTUNG ZUM FILTERN VON ELEKTROMAGNETISCHER STRAHLUNG, LUFT- UND RAUMFAHRZEUG UND VERFAHREN ZUM HERSTELLEN DER VORRICHTUNG**

(30) Priorität: 07.09.2018 DE 102018121826
(71) Anmelder: Airbus Defence and Space GmbH, 82024 Taufkirchen (DE)
(72) Erfinder: Khan, Mohammad Danish, 82024 Taufkirchen (DE)
(74) Vertreter: LKGLOBAL Lorenz & Kopf PartG mbB Patentanwälte

(57) **Zusammenfassung**

Die Erfindung betrifft eine 1. Vorrichtung zum Filtern von elektromagnetischer Strahlung, wobei die Vorrichtung (10) mindestens eine Schicht (12, 14, 16, 18) aufweist, wobei die mindestens eine Schicht (12-18) ein elektrisch isolierendes Material (21) aufweist, in das eine Vielzahl von Partikeln (20) einbettet ist, wobei die Vielzahl der Partikel (20) einen vorbestimmten mittleren Abstand zueinander aufweisen, wobei die mindestens eine Schicht (12-18) einen eigenen vorbestimmten mittleren Abstand zwischen der Vielzahl von Partikeln (20) aufweist, und wobei der vorbestimmte mittlere Abstand derart gewählt ist, dass elektromagnetische Wellen (22) mit einer Frequenz in einem Frequenzbereich oberhalb einer Grenzfrequenz beim Passieren der Vielzahl der Partikel (20) mehrheitlich gedämpft werden und elektromagnetische Wellen (22) mit einer Frequenz unterhalb der Grenzfrequenz mehrheitlich reflektiert werden. Mit der Erfindung wird eine verbesserte Vorrichtung (10) zum Filtern elektromagnetischer Strahlung und ein Verfahren (100) zu deren Herstellung bereitgestellt.

## Beschreibung

Die Erfindung betrifft eine Vorrichtung zum Filtern von elektromagnetischer Strahlung, ein Luft- und Raumfahrzeug und ein Verfahren zum Herstellen der Vorrichtung.

Durch elektromagnetische Felder können in einem Volumen, in dem sich elektrische Geräte und Kabel befinden, Spannungen und Ströme induziert werden, die Funktionsstörungen oder Abweichungen von ihren gewünschten Leistungsspezifikationen verursachen. Diese Volumina können beispielsweise in einer Flugzeugkabine, an Bord eines Raumfahrzeugs, in einem Kraftfahrzeug oder in einer Hubschrauberkabine usw. angeordnet sein. Dies kann zum Verlust der Systemleistung oder zu Fehlfunktionen des elektrischen Geräts führen. So können z. B. Mobiltelefone aufgrund von Feldkopplung eine unerwünschte Kopplung an Kabelbäumen an Bord von Flugzeugen verursachen. Diese können Störungen in der Bordelektronik verursachen.

Zur Abschirmung von Raumbereichen gegen äußere elektrische Felder ist es bekannt, einen Faraday Käfig mittels einer elektrisch leitenden Ummantelung bereitzustellen. Der Faraday Käfig umschließt dabei das zu schützende Volumen. So können z. B. Kabel mit einem Metallnetz umschlossen werden, um die Leiter im Kabel gegen äußere elektrische Felder abzuschirmen. Anstatt eines Metallnetzes ist es auch bekannt, eine Mantelschicht aus leitendem Kunststoffmaterial bereitzustellen. Allerdings ist eine Nachrüstung aufwendig, wobei der Aufwand des Nachrüstens mit der Größe des abzuschirmenden Bereichs steigt.

Aufgabe der Erfindung ist es, eine verbesserte Vorrichtung zum Filtern elektromagnetischer Strahlung und ein Verfahren zu deren Herstellung bereitzustellen.

Die Aufgabe wird gelöst durch die Merkmale der unabhängigen Ansprüche. Vorteilhafte Weiterbildungen sind Gegenstand der abhängigen Ansprüche sowie der folgenden Beschreibung.

Bei einer Vorrichtung zum Filtern von elektromagnetischer Strahlung, ist vorgesehen, dass die Vorrichtung mindestens eine Schicht aufweist, wobei die mindestens eine Schicht ein elektrisch isolierendes Material aufweist, in das eine Vielzahl von Partikeln einbettet ist, wobei die Vielzahl der Partikel einen vorbestimmten mittleren Abstand zueinander aufweisen, wobei die mindestens eine Schicht einen eigenen vorbestimmten mittleren Abstand zwischen der Vielzahl von Partikeln aufweist, und wobei der vorbestimmte mittlere Abstand derart gewählt ist, dass elektromagnetische Wellen mit einer Frequenz in einem Frequenzbereich oberhalb einer Grenzfrequenz beim Passieren der Vielzahl der Partikel mehrheitlich gedämpft werden und elektromagnetische Wellen mit einer Frequenz unterhalb der Grenzfrequenz mehrheitlich reflektiert werden.

Mit der Erfindung wird eine Vorrichtung bereitgestellt, die mindestens eine Schicht umfasst, die ein elektrisch isolierendes Material und darin eingebettete Partikel aufweist. Weiter weist die Schicht eine elektromagnetische Grenzfrequenz auf, wobei elektromagnetische Strahlung mit einer höheren Frequenz in einem Frequenzbereich oberhalb der Grenzfrequenz gedämpft wird. Die Dämpfung kann durch Absorption der elektromagnetischen Strahlung erfolgen. Damit werden die elektromagnetischen Wellen gefiltert. Die Grenzfrequenz der Schicht wird durch einen mittleren Abstand zwischen den Partikeln festgelegt, die in die Schicht eingebettet sind. Die Partikel weisen im Vergleich zu dem elektrisch isolierenden Material der Schicht unterschiedliche elektrische Eigenschaften hinsichtlich der Permeabilität, der Leitfähigkeit und weiterer elektrischer Eigenschaften auf. Der mittlere Abstand bestimmt die Dichte der Partikel in der Schicht. Mittels der Partikeldichte in der Schicht können die oben genannten elektrischen Eigenschaften in der Schicht an die benötigte Grenzfrequenz angepasst werden.

Auf diese Weise kann mittels der aus der Partikeldichte resultierenden elektrischen Eigenschaften die für diese Schicht gewünschte Grenzfrequenz eingestellt werden. Auf diese Weise muss lediglich eine Schicht um das elektrisch oder magnetisch zu isolierende Volumen aufgetragen werden, wenn eine elektrische oder magnetische Abschirmung bereitgestellt werden soll. Im Falle einer Flugzeugkabine kann zum Beispiel eine Wand mit dieser Schicht versehen werden. Dieses ohne großen Aufwand auch nachträglich möglich. Damit stellt die Erfindung eine verbesserte Vorrichtung zum Filtern elektromagnetischer Strahlung bereit.

Die Grenzfrequenz kann dabei eine erste Grenzfrequenz sein, wobei eine zweite Grenzfrequenz gewählt werden oder existieren kann, die größer als die erste Grenzfrequenz ist, oberhalb der das Material für elektromagnetische Strahlung transparent ist.

Die Vorrichtung kann eine Vielzahl von aufeinander folgenden Schichten aufweisen.

Dabei können in den verschiedenen Schichten verschiedene Materialien für die Partikel zum Einsatz kommen. Auch die Größe und Form der Partikel kann von Schicht zu Schicht variieren. Auf diese Weise kann jede Schicht auf das Filtern von bestimmten Frequenzen elektromagnetischer Strahlung optimiert werden.

Dabei kann sich der vorbestimmte mittlere Abstand zwischen einer ersten der Vielzahl der aufeinander folgenden Schichten und einer letzten der Vielzahl von aufeinander folgenden Schichten stetig ändern.

Damit werden durch die damit einhergehende steigende Partikeldichte die elektrischen Eigenschaften der aufeinander folgenden Schichten mit jeder Schicht den elektrischen Eigenschaften der Partikel angenähert. Auf diese Weise weist jeder der nachfolgenden Schichten eine stetig geänderte, d.h. entweder eine immer niedrigere oder eine immer höhere, Grenzfrequenz als die vorhergehenden Schichten auf. Die erste Schicht kann dabei zum Beispiel die unterste Schicht der Vorrichtung sein. Jede danach aufgetragene Schicht umfasst dann z. B. eine niedrigere bzw. höhere Grenzfrequenz als die davor aufgetragene Schicht, auf der die danach aufgetragene Schicht aufgetragen wird.

Gemäß einem Beispiel, bildet die Vielzahl von Partikeln im Wesentlichen eine Raumgitterstruktur.

Durch das Bilden einer Raumgitterstruktur wird eine homogene Dichteverteilung der Partikel in der Schicht bewirkt. Damit sind auch die elektrischen Eigenschaften der Schicht homogen verteilt.

Nach einem weiteren Bespiel ist das elektrisch isolierende Material ein Polymermaterial, vorzugsweise ein Harz.

Damit können die Schichten ohne großen Aufwand auf ein Substrat wie zum Beispiel auf eine Kabinenwand eines Fahrzeugs aufgetragen werden. Auch ein nachträgliches Auftragen und Ergänzen von Schichten ist ohne großen Aufwand möglich.

Die Vielzahl der Partikel können weiter Mikropartikel oder Nanopartikel sein.

Die Partikel können sich damit während der Herstellung in der Schicht gut verteilen und die Partikeldichte kann durch die kleine Größe der Partikel in sehr kleinen Schritten geändert oder angepasst werden.

Weiter kann die Vielzahl von Partikeln aus einem nicht leitenden Oxid magnetischer und/oder elektrisch leitender Materialien bestehen.

Die Partikel selbst sind damit nicht leitfähig, sodass innerhalb der Schicht keine elektrischen Ströme fließen. Die Abschirmung wird durch die Änderung der elektrischen Eigenschaften der Schicht durch die Partikeldichte bewirkt.

Gemäß einem weiteren Beispiel kann eine Schicht einen Bandpassfilter bilden.

Der Bandpassfilter ist dabei für ein Frequenzintervall elektromagnetischer Strahlung durchlässig. Oberhalb der Grenzfrequenz wird trotz der Dämpfung ein Teil der elektromagnetischen Strahlung durchgelassen. Unterhalb der Grenzfrequenz wird die elektromagnetische Strahlung reflektiert. Das Frequenzintervall endet dabei an einer zweiten oberen Grenzfrequenz, ab der weder die Partikel noch das nicht isolierende Material der Schicht eine Absorptions- oder Reflexionswirkung für die elektromagnetische Strahlung oberhalb der zweiten Grenzfrequenz bewirken.

Weiter können die Schichten miteinander verklebt sein.

Die Schichten können damit vorab hergestellt werden und auf einem Träger bereitgestellt werden. In einem ersten Beispiel können die Träger der Schichten miteinander verklebt werden, sodass ein Laminat entsteht, das die Schichten aufweist. In einem alternativen Beispiel können die Schichten mittels des Trägers auf eine andere als Substrat wirkende Schicht geklebt werden, wobei der Träger dann entfernt wird. In einer weiteren Alternative können die Schichten in flüssiger Form aufeinander aufgetragen werden, wobei jede Schicht zunächst aushärtet bevor die nächste Schicht auf sie aufgetragen wird.

Bei einem Luft- und Raumfahrzeug umfassend eine Passagierkabine mit einer Innenwand und eine Vorrichtung nach der vorangegangenen Beschreibung, ist vorgesehen, dass die mindestens eine Schicht auf der Innenwand angeordnet ist.

Dabei kann die einem Innenraum, der von der Innenwand umschlossen wird, am nächsten liegende Schicht der Vielzahl von aufeinander folgenden Schichten den größten vorbestimmten mittleren Abstand der Vielzahl von aufeinander folgenden Schichten aufweisen.

D.h., dass die der Innenwand am nächsten liegende Schicht die niedrigste Grenzfrequenz aufweist.

Die Vorteile und Weiterbildungen des Luft- und Raumfahrzeugs entsprechenden den Vorteilen und Weiterbildungen der oben genannten Vorrichtung. Daher wird in dieser Hinsicht auf die vorangegangene Beschreibung verwiesen.

Weiter vorgesehen ist ein Verfahren zum Herstellen einer Vorrichtung zum Filtern von elektromagnetischer Strahlung nach der vorangegangenen Beschreibung, wobei das Verfahren die folgenden Schritte aufweist: Wählen einer Grenzfrequenz für einen Frequenzbereich, Ableiten eines vorbestimmten mittleren Abstands für Partikel aus der Grenzfrequenz, Erzeugen einer Mischung einer Vielzahl von Partikeln mit einem elektrisch isolierenden Material mit einer vorbestimmten Partikeldichte, bei der die Vielzahl der Partikel den vorbestimmten mittleren Abstand zueinander aufweist, um eine Vorrichtung zum Filtern von elektromagnetischer Strahlung herzustellen.

Weiter kann das Verfahren folgende Schritte aufweisen: Auftragen einer weiteren Schicht mit dem elektrisch isolierenden Material, in das eine Vielzahl von Partikeln mit einem zu der aufgetragenen oder aufgeklebten Schicht unterschiedlichen vorbestimmten mittleren Abstand zueinander eingebettet ist, und wobei die vorangegangenen Schritte mindestens ein Mal durchgeführt werden, wobei bei jeder Durchführung eine unterschiedliche Grenzfrequenz gewählt wird.

Nach einem Beispiel kann bei jeder Wiederholung eine stetig wachsende oder fallende Grenzfrequenz gewählt werden.

Weitere Vorteile und Weiterbildungen des Verfahrens können der vorangegangenen Beschreibung hinsichtlich der Vorrichtung und des Luft- und Raumfahrzeugs entnommen werden.

Im Folgenden wird die Erfindung anhand einer beispielhaften Ausführungsform mittels der beigefügten Zeichnung beschrieben. Es zeigen:
- Figur 1: eine schematische Querschnittsdarstellung der Schichten der Vorrichtung;
- Figur 2: eine schematische Querschnittsdarstellung einer Flugzeugkabine;
- Figur 3a, b: eine schematische Darstellung eines Flugzeugs bzw. Raumfahrzeugs mit der Vorrichtung; und
- Figur 4: ein Flussdiagramm des Verfahrens.

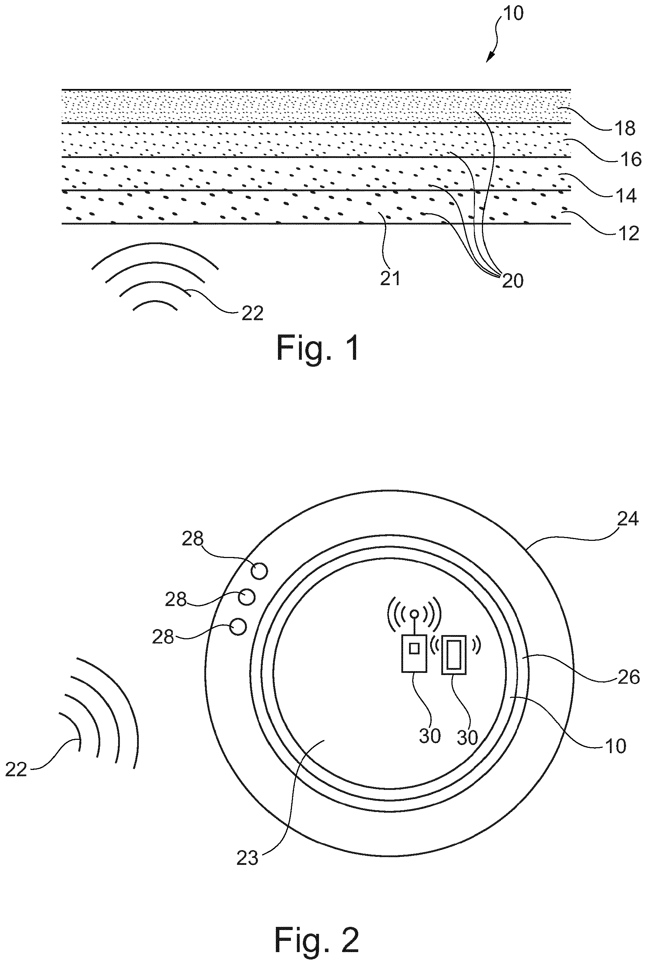

Die Vorrichtung zum Filtern von elektromagnetischer Strahlung wird im Folgenden in ihrer Gesamtheit mit dem Bezugszeichen 10 bezeichnet, wie in Figur 1 dargestellt.

Die Vorrichtung 10 weist eine Vielzahl von aufeinander folgenden Schichten 12, 14, 16, 18 auf. Die Schichten 12, 14, 16, 18 sind lagenweise aufeinander angeordnet und sind unter anderem aus einem elektrisch isolierenden Material 21, wie zum Beispiel einem Polymermaterial, das vorzugsweise ein Harz sein kann, hergestellt. Innerhalb der Schichten 12, 14, 16, 18 und zwischen den Schichten 12, 14, 16, 18 kann deswegen kein elektrischer Strom fließen.

Die Schichten 12, 14, 16, 18 können dabei miteinander verklebt sein, wobei die Klebeschicht (nicht dargestellt) in diesem Beispiel dann zwischen den Schichten 12, 14, 16, 18 angeordnet ist. In einem anderen Beispiel können die Schichten 12, 14, 16, 18 nacheinander aufeinander aufgetragen worden sein, wobei jede Schicht 12, 14, 16, 18 zunächst aushärtet, bevor die nächste Schicht auf sie aufgetragen wird.

In das elektrisch isolierende Material 21 der Schichten 12, 14, 16, 18 ist eine Vielzahl von Partikeln 20 eingebettet. Die Partikel 20 haben im Vergleich zu dem elektrisch isolierenden Material 21 verschiedene elektrische Eigenschaften hinsichtlich der Permeabilität, der Leitfähigkeit und weiterer elektrischer Eigenschaften. Das Einbetten der Partikel 20 mit dem isolierenden Material 21 verändert daher die elektrischen Eigenschaften der Schichten 12, 14, 16, 18 so, dass sie sich mit zunehmender Partikeldichte den elektrischen Eigenschaften der Partikel 20 annähern.

D.h., dass mit geringer Partikeldichte die elektrischen Eigenschaften der Schichten 12, 14, 16, 18 näher an den elektrischen Eigenschaften des isolierenden Materials 21 liegen als bei hoher Partikeldichte. Auf diese Weise können die elektrischen Eigenschaften der Schichten 12, 14, 16, 18 zwischen den elektrischen Eigenschaften des isolierenden Materials 21 und den elektrischen Eigenschaften der Partikel 20 mittels der Partikeldichte, d.h. dem mittleren Abstand zwischen den Partikeln 20, eingestellt werden.

Die elektrischen Eigenschaften der Schichten 12, 14, 16, 18 bewirken, dass eine Grenzfrequenz eingestellt wird, oberhalb der elektromagnetische Strahlung in einem Frequenzbereich durch die Schichten 12, 14, 16, 18 absorbiert wird. Unterhalb dieser Grenzfrequenz wird die elektromagnetische Strahlung reflektiert. Alternativ können die Schichten 12, 14, 16, 18 unterhalb der Grenzfrequenz für die elektromagnetische Strahlung mit der entsprechenden Frequenz transparent sein. In der Regel weist jedes Material eine zweite Grenzfrequenz auf, oberhalb der das Material für die elektromagnetischen Wellen transparent ist. D.h., dass mit der Partikeldichte der Partikel 20 in den Schichten 12, 14, 16, 18 eine erste Grenzfrequenz für den Frequenzbereich festgelegt wird, wobei elektromagnetische Wellen, die eine Frequenz zwischen der ersten Grenzfrequenz und der zweiten Grenzfrequenz aufweisen, zum größten Teil durch die Schichten 12, 14, 16, 18 absorbiert werden. Ein Teil der elektromagnetischen Strahlung in diesem Frequenzbereich kann jedoch auch durchgelassen werden.

Die Partikel 20, die für die verschiedenen Schichten 12, 14, 16, 18 verwendet werden, können von Schicht zu Schicht variieren. D.h., dass die Vorrichtung 10 in jeder Schicht unterschiedliche Partikel 20 aufweisen kann, wobei sich die Partikel 20 in Material, Form und Größe von Schicht zu Schicht unterscheiden können. Die Partikel 20 können weiter Mikro- oder Nanopartikel sein und aus einem nicht-leitenden Metalloxid bestehen.

Die Schicht mit dem Referenzzeichen 12 weist in Figur 1 die geringste Partikeldichte auf. Die nachfolgende Schicht mit dem Referenzzeichen 14 weist eine höhere Partikeldichte auf. Dies setzt sich bis zur Schicht 18 fort, die in diesem Beispiel die größte Partikeldichte aufweist. Die Anzahl der Schichten in Figur 1 ist dabei willkürlich gewählt. Es können daher auch mehr oder weniger Schichten 12 bis 18 vorhanden sein. Ebenso kann auch eine einzige Schicht 12 bis 18 vorhanden sein.

Die Schichten 12 bis 18, die auf diese Weise aufgebaut sind, können dabei Bandpassfilter darstellen, die einen bestimmten Frequenzbereich filtern. Elektromagnetische Strahlung 22, die auf die Schichten der Vorrichtung trifft, wird beim Durchlaufen der Schichten 12 bis 18 gedämpft, wenn diese elektromagnetische Strahlung 22 eine Frequenz oberhalb der unteren Grenzfrequenz und unterhalb der oberen Grenzfrequenz aufweist.

Figur 2 zeigt einen Querschnitt durch eine Passagierkabine 26 eines Flugzeugs 24. Zwischen der Passagierkabine 26 und der Außenwand des Flugzeugs 24 sind Kabel 28 angeordnet. Im Innenraum 23 der Passagierkabine 26 werden elektrische Geräte 30 benutzt, die elektromagnetische Strahlung aussenden. Ebenso kann elektromagnetische Strahlung 22 von außen auf das Flugzeug treffen, wobei die Außenhaut des Flugzeugs 24 in der Regel aus einem metallischen Material hergestellt ist, das einen Faraday Käfig für von außen auftretende elektromagnetische Strahlung 22 bildet. Elektromagnetische Strahlung 22 von außen kann lediglich an bestimmten Stellen, wie zum Beispiel den Fenstern in das Innere des Flugzeugs 24 eindringen.

Die Passagierkabine 26 weist die Vorrichtung 10 auf. D.h., dass eine Wand der Passagierkabine 26 bzw. die gesamte Wand mit den Schichten 12 bis 18 der Vorrichtung 10 beschichtet ist. Die einzelnen Schichten 12 bis 18 können dabei jeweils Abmessungen von einigen Millimetern aufweisen.

Am Beispiel einer Abschirmung zum Filtern von elektromagnetischer Strahlung, die während eines Flugs von Mobiltelefonen zu den Funkmasten auf der Erde ausgesendet wird und im Bereich von 900 MHz liegt, kann die innerste Schicht 12 in der Passagierkabine 26, die gleichzeitig am weitesten von der Wand der Passagierkabine 26 entfernt ist, eine Partikeldichte aufweisen, die einer Dämpfung in einem Frequenzbereich von zum Beispiel 300 MHz bis 3 GHz bereitstellt. D.h., dass in diesem Bereich die elektromagnetischen Wellen gefiltert werden.

Die nächste Schicht 14 kann eine Partikeldichte aufweisen, die eine Absorption zwischen 700 MHz und 2 GHz bereitstellt. Dabei können auch andere Partikel 20 als in der innersten Schicht 12 in die Schicht 14 eingebettet sein.

Die äußerste Schicht 18, die an der Wand der Passagierkabine 26 angeordnet ist und an ihr befestigt sein kann, kann eine Absorption im Bereich von 900 MHz aufweisen. Auf diese Weise werden schrittweise die Frequenzen im Bereich von 900 MHz von innen nach außen in der Passagierkabine gefiltert. Die Frequenzen um 900 MHz erreichen damit die Kabel 28 nicht mehr und können nur bedingt Spannungen in den Kabeln 28 induzieren. Weiter werden die Frequenzen um 900 MHz von allen Schichten gefiltert, sodass in diesem Frequenzbereich die Dämpfungsfunktion am größten ist. Die umliegenden Frequenzen werden jeweils von den anderen Schichten schrittweise abgeschwächt.

Falls der Frequenzbereich, in dem eine Dämpfung stattfinden soll, vergrößert werden soll, kann auf die Schicht 12 eine weitere Schicht aufgetragen werden, mit einer Partikeldichte die geringer als die der Schicht 12 ist. Weiter können andere Partikel in dieser Schicht, die auf die Schicht 12 aufgetragen wird, verwendet werden, um den Dämpfungseffekt in einem größeren Frequenzbereich bereitzustellen.

Es versteht sich von selbst, dass die Frequenzbereiche auch anders ausgestaltet werden können. So kann zum Beispiel jede Schicht elektromagnetische Strahlung in einem Frequenzbereich von einer bestimmten ersten Grenzfrequenz bis zu einer gemeinsamen zweiten Grenzfrequenz von zum Beispiel 4 GHz dämpfen.

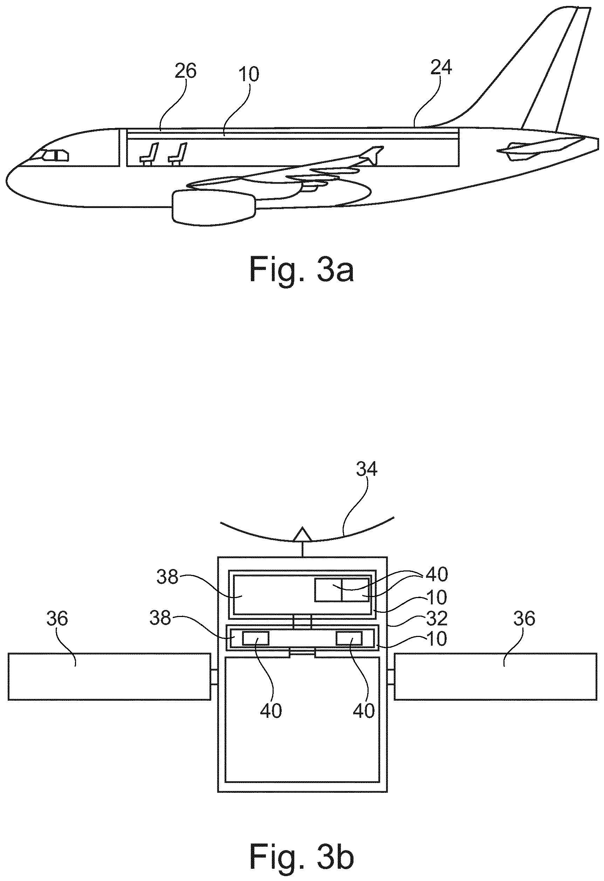

Figur 3a zeigt ein Flugzeug 24, in dem die Vorrichtung 10 befestigt ist. Die Erfindung kann jedoch auch in anderen Bereichen eingesetzt werden, so kann die Vorrichtung 10 in einem Helikopter, in einem Raumfahrzeug 32, in einem Kraftfahrzeug, in Gehäusen elektronischer Geräte oder weiteren Vorrichtungen verwendet werden.

Figur 3b zeigt dabei ein Beispiel eines Raumfahrzeugs 32 mit der Vorrichtung 10. Das Raumfahrzeug 32 kann dabei mehrere Räume 38 aufweisen in denen sich elektronische Geräte 40 befinden. Die Wände der Räume 38 umfassen die Vorrichtung 10. Auf diese Weise beeinflussen die elektronischen Geräte 40 des einen Raumes nicht die elektronischen Geräte 40 der anderen Räume. Auch Antennen 34, die außen an dem Raumfahrzeug 32 angeordnet sein können, werden durch die elektronischen Geräte 40 in den Räumen des Raumfahrzeugs 32 nicht beeinflusst.

Weiter können elektromagnetische Felder, die durch Solarpaneele 36 des Raumfahrzeugs erzeugt werden, durch die Vorrichtung abgeschirmt werden, so dass die elektronischen Geräte 40 nicht durch diese Felder beeinflusst werden.

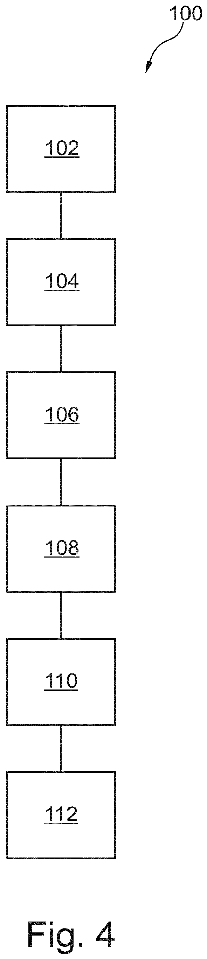

Figur 4 zeigt ein Flussdiagramm des Verfahrens 100 zum Herstellen einer oben beschriebenen Vorrichtung zum Filtern von elektromagnetischer Strahlung. Das Verfahren 100 weist in einem ersten Schritt 102 das Wählen einer Grenzfrequenz für einen Frequenzbereich auf. Mit dem Wählen der Grenzfrequenz für einen Frequenzbereich wird festgelegt, oberhalb welcher Grenzfrequenz elektromagnetische Strahlung gedämpft werden soll. Die meisten Materialien weisen dabei automatisch eine zweite Grenzfrequenz auf, die größer als die gewählte Grenzfrequenz ist. Oberhalb der zweiten Grenzfrequenz ist das Material für elektromagnetische Strahlung transparent.

In einem weiteren Schritt 104 wird mittels der Grenzfrequenz ein vorbestimmter mittlerer Abstand bzw. eine Partikeldichte für die Partikel, die in der Vorrichtung bzw. der betreffenden Schicht verwendet werden können, abgeleitet. Dabei kann die Grenzfrequenz auch das Material, die Form und die Größe der Partikel festlegen.

In einem weiteren Schritt 106 wird eine Mischung aus einer Vielzahl der gewählten Partikel mit einem elektrischen isolierenden Material gebildet. Dabei hat die Mischung die abgeleitete Partikeldichte, bei der die Vielzahl der Partikel den vorbestimmten mittleren Abstand zueinander aufweist. Auf diese Weise wird das Material einer Schicht gebildet, die einen bestimmten Frequenzbereich oberhalb der Grenzfrequenz filtert. Unter Filterung kann dabei auch eine Dämpfung oder Absorption verstanden werden.

In einem Schritt 108 wird die Schicht bestehend aus der Mischung auf ein Trägermaterial aufgetragen oder aufgeklebt. Damit wird eine Vorrichtung zum Filtern von elektromagnetischer Strahlung hergestellt. Die Filterung erfolgt dabei in dem Bereich oberhalb der Grenzfrequenz. Der Frequenzbereich, in dem die Filterung erfolgt, kann dabei durch eine zweite Grenzfrequenz, die über der gewählten Grenzfrequenz liegt, begrenzt werden.

In einem Schritt 110 kann das Verfahren zusätzlich den Schritt aufweisen, dass eine weitere Schicht mit dem elektrischen isolierenden Material aufgetragen wird, wobei in dieser weiteren Schicht eine Vielzahl von Partikeln eingebettet ist, die einen zu der im Schritt 108 aufgetragenen Schicht unterschiedlichen vorbestimmten mittleren Abstand zueinander aufweisen. Damit ist die Partikeldichte in der weiteren Schicht anders als in der Schicht, die in Schritt 108 aufgetragen wurde. Auf diese Weise kann eine weitere Schicht für die Vorrichtung hergestellt werden, um entweder einen Unterbereich des Frequenzbereiches, der von der ersten Schicht gedämpft wird, zu dämpfen, oder einen größeren Frequenzbereich als den Frequenzbereich, der von der ersten Schicht gedämpft wird, zu dämpfen.

Gemäß Schritt 112 kann Schritt 110 mindestens einmal durchgeführt werden, wobei bei jeder Durchführung eine unterschiedliche Grenzfrequenz gewählt wird. D.h., dass mehrere weitere Schichten aufgetragen werden können, wobei jede der weiteren Schichten eine individuelle Grenzfrequenz aufweist. Es weist dann keine der weiteren Schichten die gleiche Grenzfrequenz auf.

Damit sei aber nicht ausgeschlossen, dass in einem Herstellungsverfahren auch die gleiche Grenzfrequenz für alle Schichten verwendet wird.

Bevorzugt ist es jedoch, wenn bei jeder Wiederholung eine größere Grenzfrequenz gewählt wird. Wenn davon ausgegangen wird, dass die zweite Grenzfrequenz, die größer als die gewählte Grenzfrequenz ist bei allen Schichten gleich ist, wird der Frequenzbereich, in dem eine Dämpfung stattfindet, mit jeder Wiederholung kleiner.

Weiter kann auch eine zweite Grenzfrequenz gewählt werden, wobei diese zweite Grenzfrequenz jeder Wiederholung kleiner wird. Da die erste Grenzfrequenz, die der gewählten Grenzfrequenz aus Schritt 102 entspricht, immer größer wird, weisen die weiteren Schichten mit jeder Wiederholung einen schmaleren Frequenzbereich auf, der innerhalb des Frequenzbereiches der vorher aufgetragenen Schicht liegt. Auf diese Weise kann um eine bestimmte zu dämpfende Frequenz herum ein Dämpfungsbereich hergestellt werden, indem die Frequenzen je weiter sie von der zu dämpfenden Frequenz entfernt sind, schwächer gedämpft werden.

Alternativ kann die erste und/oder zweite Grenzfrequenz bei jeder Wiederholung auch immer größer ausgebildet werden. Weiter können die Grenzfrequenzen von Schicht zu Schicht alternieren oder konstant bleiben.

## Patentansprüche

1. Vorrichtung zum Filtern von elektromagnetischer Strahlung, wobei die Vorrichtung (10) mindestens eine Schicht (12, 14, 16, 18) aufweist,
wobei die mindestens eine Schicht (12-18) ein elektrisch isolierendes Material (21) aufweist, in das eine Vielzahl von Partikeln (20) einbettet ist, wobei die Vielzahl der Partikel (20) einen vorbestimmten mittleren Abstand zueinander aufweisen,
wobei die mindestens eine Schicht (12-18) einen eigenen vorbestimmten mittleren Abstand zwischen der Vielzahl von Partikeln (20) aufweist, und
wobei der vorbestimmte mittlere Abstand derart gewählt ist, dass elektromagnetische Wellen (22) mit einer Frequenz in einem Frequenzbereich oberhalb einer Grenzfrequenz beim Passieren der Vielzahl der Partikel (20) mehrheitlich gedämpft werden und elektromagnetische Wellen (22) mit einer Frequenz unterhalb der Grenzfrequenz mehrheitlich reflektiert werden.

2. Vorrichtung nach Anspruch 1, wobei die Vorrichtung eine Vielzahl von aufeinander folgenden Schichten (12-18) aufweist.

3. Vorrichtung nach Anspruch 2, wobei sich der vorbestimmte mittlere Abstand zwischen einer ersten der Vielzahl der aufeinander folgenden Schichten (12-18) und einer letzten der Vielzahl von aufeinander folgenden Schichten (12-18) ändert.

4. Vorrichtung nach einem der Ansprüche 2 bis 3, wobei die Schichten (12-18) miteinander verklebt sind.

5. Vorrichtung nach Anspruch 1 bis 4, wobei Vielzahl von Partikeln (20) im Wesentlichen eine Raumgitterstruktur bilden.

6. Vorrichtung nach einem der Ansprüche 1 bis 5, wobei das elektrisch isolierende Material (21) ein Polymermaterial, vorzugsweise ein Harz, ist.

7. Vorrichtung nach einem der Ansprüche 1 bis 6, wobei die Vielzahl von Partikeln (20) Mikropartikel oder Nanopartikel sind.

8. Vorrichtung nach einem der Ansprüche 1 bis 7, wobei die Vielzahl von Partikeln (20) aus einem nicht leitenden Oxid magnetischer und/oder elektrisch leitender Materialien besteht.

9. Vorrichtung nach einem der Ansprüche 1 bis 8, wobei die mindestens eine Schicht (12-18) einen Bandpassfilter bildet.

10. Luft- und Raumfahrzeug (24) umfassend
eine Passagierkabine (26) mit einer Innenwand und
eine Vorrichtung (10) nach einem der vorhergehenden Ansprüche,
wobei, die mindestens eine Schicht auf der Innenwand angeordnet ist.

11. Luft- und Raumfahrzeug nach Anspruch 10, wobei die einem Innenraum (23), der von der Innenwand umschlossen wird, am nächsten liegende Schicht der Vielzahl von aufeinander folgenden Schichten (12-18) den größten vorbestimmten mittleren Abstand der Vielzahl von aufeinander folgenden Schichten (12-18) aufweist.

12. Verfahren zum Herstellen einer Vorrichtung zum Filtern von elektromagnetischer Strahlung nach einem der Ansprüche 1 bis 9, wobei das Verfahren (100) die folgenden Schritte aufweist:
- Wählen (102) einer Grenzfrequenz für einen Frequenzbereich,
- Ableiten (104) eines vorbestimmten mittleren Abstands für Partikel aus der Grenzfrequenz,
- Erzeugen (106) einer Mischung einer Vielzahl von Partikeln mit einem elektrisch isolierenden Material mit einer vorbestimmten Partikeldichte, bei der die Vielzahl der Partikel den vorbestimmten mittleren Abstand zueinander aufweist, und
- Auftragen oder Aufkleben (108) einer Schicht aus der Mischung auf ein Trägermaterial,
um eine Vorrichtung zum Filtern von elektromagnetischer Strahlung herzustellen.

13. Verfahren nach Anspruch 12, wobei das Verfahren zusätzlich die nachfolgenden Schritte aufweist:
- Auftragen (110) einer weiteren Schicht mit dem elektrisch isolierenden Material, in das eine Vielzahl von Partikeln mit einem zu der aufgetragenen oder aufgeklebten Schicht unterschiedlichen vorbestimmten mittleren Abstand zueinander eingebettet ist, und
wobei die vorangegangenen Schritte mindestens ein Mal durchgeführt werden, wobei bei jeder Durchführung eine unterschiedliche Grenzfrequenz gewählt (112) wird.

14. Verfahren nach Anspruch 12 oder 13, wobei bei jeder Wiederholung eine wachsende oder fallende Grenzfrequenz gewählt wird.
